# EUROPÄISCHE PATENTANMELDUNG

(11) **EP 1 480 077 A2**
(43) Veröffentlichungstag der Anmeldung: **24.11.2004**
(21) Anmeldenummer: 04010727.8
(22) Anmeldetag: 06.05.2004
(51) Int. Cl.: G03F 1/00

(54) **Vorrichtung und Verfahren zur Herstellung geprägter Substrate**

(30) Priorität: 21.05.2003 DE 10323365
(71) Anmelder: Robert Bürkle GmbH, 72250 Freudenstadt (DE)
(72) Erfinder: Damm, Norbert, 76689 Karlsdorf-Neuthard (DE); Dölker, Gerhard Albert, 72270 Baiersbronn (DE)
(74) Vertreter: Brommer, Hans Joachim, Dr.-Ing.

(57) **Zusammenfassung**

Die Erfindung betrifft eine Vorrichtung zur Herstellung geprägter Substrate, insbesondere mit dreidimensionalen Oberflächenstrukturen, indem das Substrat zwischen zwei verfahrbaren Pressplatten und zumindest einer Prägematrize unter Druck- und Wärmeeinwirkung geprägt wird. Vor dem Prägen werden die Prägematrize(n) und/oder das Substrat senkrecht zur Hubrichtung durch thermisch aktivierte Dehnglieder ausgerichtet.

## Beschreibung

Die Erfindung betrifft eine Vorrichtung und ein Verfahren zur Herstellung einseitig oder beidseitig geprägter Substrate, insbesondere mit Oberflächenstrukturen im Mikro- oder Nanobereich, indem das Substrat zwischen zwei verfahrbaren Pressplatten und zumindest einer Prägematrize unter Druck- und Wärmeeinwirkung, gegebenenfalls unter Zwischenschaltung weiterer Teile, Druckkissen oder dergleichen, geprägt wird, wobei die Prägematrize und/oder das Substrat vor dem Prägen senkrecht zur Hubrichtung relativ zueinander durch Stell-Aktuatoren auszurichten sind.

Bei elektronischen Bauelementen, aber auch bei anderen Anwendungsbereichen werden Substrate, meist in Form von Folien, mit dreidimensionalen Oberflächenstrukturen im Mikro- oder Nanobereich benötigt. Diese Oberflächenstrukturen werden von einem als Matrize bezeichneten Werkzeug auf das Substrat übertragen, und zwar entweder einseitig mittels einer Matrize oder simultan beidseitig mit zwei Matrizen. In beiden Fällen besteht häufig das Bedürfnis, die Prägematrize und das Substrat und/oder beide Prägematrizen relativ zueinander auszurichten, damit die eingeprägten Strukturen entweder in einer bestimmten Zuordnung zum Substrat positioniert sind oder die eingeprägten Strukturen von Oberseite und Unterseite des Substrates miteinander korrespondieren.

Eine Vorrichtung zur Herstellung einseitig geprägter Substrate mit Mikrostrukturen ist durch die DE 199 25 175 bekannt geworden. Dabei wird die Zuordnung zwischen Substrat und Matrize optisch durch CCD-Kameras mit Hilfe von Markierungen erfasst, und zwar in einer dem Prägevorgang vorangestellten Probeabformung. Aufgrund der ermittelten Ortskoordinaten der gemessenen Markierungen wird das Substrat gegenüber der Matrize mit Hilfe von Stell-Aktuatoren in die Sollposition verschoben. Als Stellaktuatoren dienen im bekannten Fall Pneumatikzylinder und verstellbare Anschläge.

Daneben sind als Stell-Aktuatoren auch Spindelantriebe oder Piezo-Stellglieder bekannt.

Diese bekannten Aktuatoren werden jedoch problematisch, wenn sie bei höheren Temperaturen eingesetzt werden sollen, insbesondere im Umfeld der Prägevorrichtung, wo sich Betriebstemperaturen bis zu 300° C einstellen, weil die bekannten Aktuatoren nur für Umgebungstemperaturen bis etwa 50° C hinreichend genau sind.

Hiervon ausgehend liegt der vorgehenden Erfindung die Aufgabe zugrunde, eine Prägevorrichtung der eingangs beschriebenen Gattung dahingehend zu verbessern, dass eine hochgenaue und zugleich hitzebeständige Ausrichtung zwischen den Prägematrizen untereinander oder relativ zum Substrat gewährleistet ist. Des weiteren soll die Erfindung ermöglichen, die Aktuatoren direkt in die Prägevorrichtung einzubauen, so dass der Mess- und Ausrichtvorgang in einer Betriebsphase durchgeführt werden kann, wo das Substrat und die Prägematrizen bereits ihre Endposition vor dem eigentlichen Prägen einnehmen.

Diese Aufgabe wird erfindungsgemäß dadurch gelöst, dass die Aktuatoren thermisch aktivierte Dehnglieder aufweisen, deren Stellweg durch Beheizung und/oder Kühlung steuerbar ist.

Der Kern der Erfindung besteht also darin, das Ausrichten der Prägematritze(n) und/oder des Substrates relativ zueinander nicht mehr mechanisch, sondern allein durch thermische Dehnung zu erzeugen. Dadurch lässt sich eine außerordentlich hohe Stellgenauigkeit erreichen: Bei Verwendung von Stahl-Schubstangen mit 100 mm Basislänge ergibt sich ein Stellweg von etwa 1 µ pro 1 grd Temperaturänderung. Bei einer geforderten Positioniergenauigkeit von +/- 3 µ muss das Temperatur-Regelverhalten für die erfindungsgemäßen Dehnglieder nur +/- 3 grd betragen. Dies ist mit den im Handel erhältlichen Thermostat-Geräten problemlos möglich.

Der Einsatz der erfindungsgemäßen Dehnglieder bei Betriebstemperaturen von etwa 300 °C ist ebenfalls unkritisch. Als Basistemperatur für die Nullstellung der Dehnglieder wird vorzugsweise etwa 40% bis etwa 50% der maximalen Stelltemperatur gewählt, um in beiden Richtungen die gewünschten Stellwege zu erzielen. Die Abmessungen der Aktuatoren in Stellrichtung, die Materialdaten und die einstellbaren Minimal- und Maximaltemperaturen sind so gewählt, dass ein Stellbereich von etwa ± 150 µ überdeckt wird.

Zwar ist es durch die US-6,666,134 bereits bekannt, bei Pressen thermisch aktivierte Dehnglieder einzusetzen. Dort werden diese Dehnglieder jedoch zur Spieleinstellung zwischen einem verfahrbaren Hubtisch und seinen Hubsäulen eingesetzt. Eine Ausrichtung der Prägematritze(n) und/oder des Substrates relativ zueinander wird dort nicht angesprochen.

Grundsätzlich bieten sich dem Fachmann für die Beheizung und Kühlung der thermischen Dehglieder verschiedene Möglichkeiten, etwa elektrisch durch Ohm'sche Erwärmung und Kühlung durch den Peltier-Effekt. Praktikabler ist aber der Einsatz von fluiden Wärmetauschmedien, insbesondere indem die Aktuatoren Strömungskanäle aufweisen, die jeweils an thermostatgesteuerte Heiz- und/oder Kühlkreisläufe angeschlossen sind. Dadurch lässt sich mit bewährter Technik eine gute Konstanthaltung der Solltemperatur wie auch eine rasche Änderung auf eine neue Solltemperatur herbeiführen.

In konstruktiver Hinsicht kommen die unterschiedlichsten Ausführungsformen für die Aktuatoren in Betracht. Als kostengünstigste Lösung empfehlen sich stangenartige Elemente, insbesondere Hohlzylinder, die innen und gegebenenfalls außen vom Heiz- bzw. Kühlmittel umströmt werden.

Es liegt durchaus im Rahmen der Erfindung, die Ausrichtung der Prägematrize(n) bzw. des Substrates nicht allein durch die erfindungsgemäßen thermisch aktivierten Dehnglieder durchzuführen, sondern diese nur zur Feinpositionierung einzusetzen und herkömmliche Stellglieder für die Grobeinstellung zu verwenden. Dabei können die thermisch aktivierten Dehnglieder mit den herkömmlichen Stellgliedern kombiniert, etwa vorne angebaut sein. Die herkömmlichen Stellglieder sollten dabei nicht der direkten Betriebstemperatur ausgesetzt sein.

Durch die hohe Hitzebeständigkeit der thermisch aktivierten Dehnglieder empfiehlt es sich, sie unmittelbar in die Prägevorrichtung einzubauen, so dass der Ausrichtvorgang unmittelbar zu Beginn des Prägevorganges stattfindet. Eventuelle Positionsveränderungen während der vorangegangenen Hubbewegung der zumindest einen Pressplatte können sich so nicht mehr negativ auf die Fertigungsqualität auswirken.

Um äußere Temperatureinflüsse auf die Aktuatoren auszuschließen, empfiehlt es sich, dass sie außen von einer Wärme-Isolierung umgeben sind. Dadurch können sie mit gegenüber der Betriebstemperatur der Prägevorrichtung stark abweichenden Temperaturen betrieben werden, woraus entsprechend große Stellwege resultieren.

Hinsichtlich der Erkennung eines Versatzes zwischen den Prägematrizen bzw. zwischen Prägematrize und Substrat bieten sich dem Fachmann ebenfalls zahlreiche Möglichkeiten. Besonders günstig ist es, die Messung des Versatzes innerhalb der Prägevorrichtung durchzuführen, vorzugsweise unmittelbar vor Beginn des Prägens, also während des Schließhubes, wenn also nur noch minimale Hubbewegungen stattfinden.

Die Messung kann optisch mit CCD-Kameras erfolgen. Dabei empfiehlt es sich, dass die Prägematrizen und/oder das Substrat optische Markierungen zur Feststellung ihrer IST-Positionen aufweisen. Diese Markierungen müssen natürlich nicht unmittelbar an der Prägematrize und dem Substrat angeordnet sein, sondern können auch an damit fest verbundenen Bauteilen vorgesehen sein. Besonders günstig ist es, wenn ein Teil der Markierungen durch Bohrungen gebildet wird und die Kameras durch diese Bohrungen hindurch die anderen Markierungen erfassen.

Des weiteren empfiehlt es sich, dass das Messsystem zur Erfassung des Versatzes an einen die erfindungsgemäßen Stellglieder umfassenden Regelkreis angeschlossen ist, so dass der gemessene Versatz automatisch beseitigt wird. Falls zwei Matrizen vorgesehen sind, genügt es, nur eine Matrize zu positionieren. Falls eine bestimmte Zuordnung der Prägematrize(n) relativ zum Substrat verlangt wird, kann stattdessen oder zusätzlich auch letzteres durch die thermisch aktivierten Dehnglieder in die Sollposition verschoben werden.

Weitere Merkmale und Vorteile der Erfindung ergeben sich aus der Beschreibung eines Ausführungsbeispieles einer erfindungsgemäßen Heiß-Prägepresse anhand der Zeichnung und der Zeichnung selbst. Dabei zeigt:
- Figur 1: eine Seitenansicht der Presse in der Offenstellung;
- Figur 2: eine Ausschnittvergrößerung aus Figur 1, jedoch bei geschlossener Presse;
- Figur 3: eine Ausschnittvergrößerung des erfindungsgemäßen Aktuators aus Figur 2;
- Figur 4: eine Draufsicht auf die obere Pressplatte mit den seitlichen Aktuatoren und Rückstellgliedern.
- Figur 5: ein Schemabild für die Steuerung des Ausrichtvorganges.

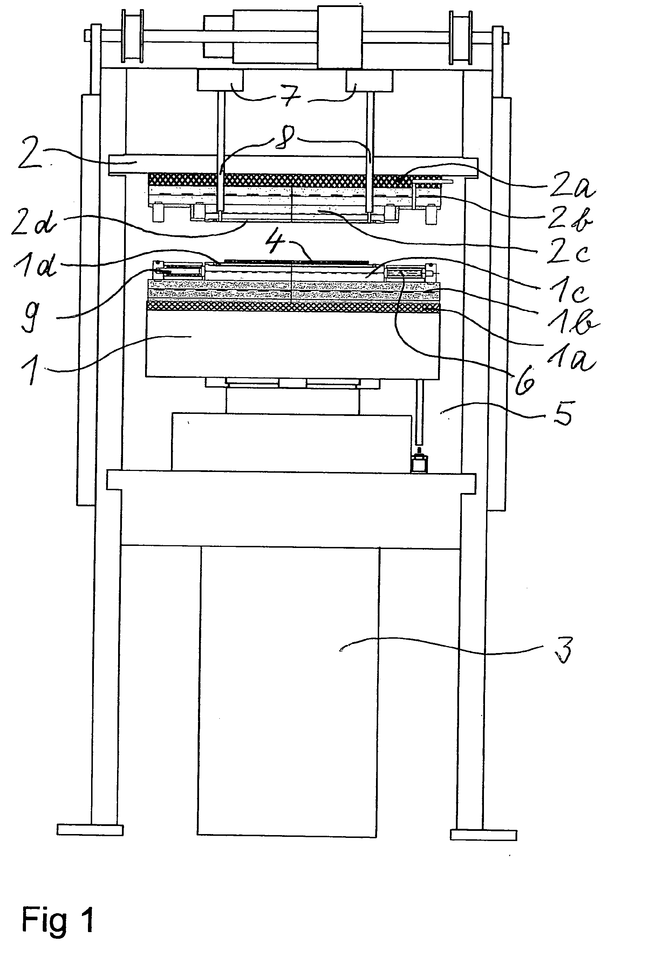

In Figur 1 ist die Prägevorrichtung in Form einer Säulenpresse dargestellt. Sie weist eine untere Pressplatte 1 und eine obere Pressplatte 2 auf. Die untere Pressplatte 1 ist an einem Hubkolben eines Hydraulikzylinders 3 montiert und kann dadurch vertikal nach oben gegen die feststehende obere Pressplatte 2 verfahren werden. Beide Pressplatten tragen an ihren einander zugewandten Seiten mehrere Zwischenlagen, insbesondere Dämpfungskissen 1a und 2a und äußere Heizplatten 1b und 2b, sowie innere Heizplatten 1c und 2c, die aber gegebenenfalls auch von einem Kühlmittel durchströmt werden können. Die innere Heizplatte 1c fungiert zugleich als Justierplatte, die horizontal verschiebbar gelagert ist und an ihrer Oberseite direkt oder indirekt das zu prägende Substrat 4 - meist in Form einer flexiblen Kunststofffolie - trägt. Im Ausführungsbeispiel trägt die Justierplatte 1c eine Prägematrize 1d, deren Oberseite die gewünschte dreidimensionale Oberflächenstruktur im Mikro- oder Nanobereich aufweist. Auf dieser Matrize liegt schließlich das Substrat 4.

Demgegenüber trägt die obere Heizplatte 2b unter Zwischenlage der inneren Heizplatte 2c eine Prägematrize 2d, deren Unterseite die gewünschte Oberflächenstruktur aufweist, die auf das darunter angeordnete Substrat 4 beim Zusammenfahren der Pressplatten übertragen werden soll.

Der eigentliche Pressraum bildet eine verschließbare Kammer 5, die evakuiert oder mit Inertgas geflutet werden kann.

Insoweit entspricht die Presse weitgehend dem bekannten Stand der Technik.

Wesentlich ist nun einerseits, dass die Justierplatte 1c mit der Prägematrize 1d und dem daraufliegenden Substrat 4 durch mehrere an zumindest einem Außenrand der Justierplatte angreifende Aktuatoren 6 innerhalb der Presse in Horizontalrichtung verschoben werden kann.

Wesentlich ist andererseits, dass in die Presse ein Messsystem integriert ist, das im Ausführungsbeispiel durch mehrere am oberen Pressenende angeordnete CCD-Kameras 7 gebildet ist und dass diese Kameras über vertikale Durchgangskanäle 8 in der Lage sind, die relative Zuordnung zwischen Substrat 4 und Prägematrize 2d in Horizontalrichtung zu erfassen.

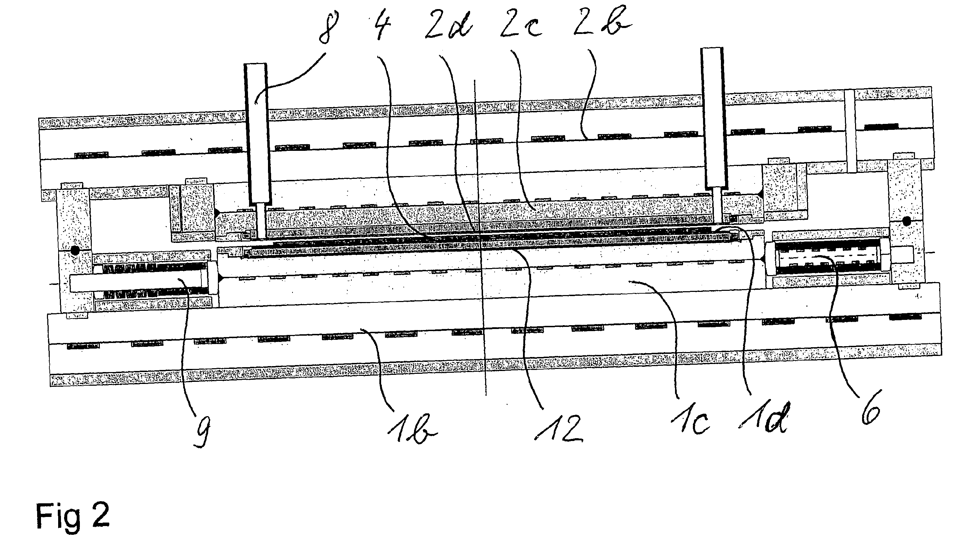

Der Aufbau der erfindungsgemäßen Aktuatoren 6 ergibt sich aus der vergrößerten Darstellung in Figur 2, wo die Presse geschlossen ist, der Feinhub für den Prägevorgang jedoch noch nicht begonnen hat. Die Justierplatte 1c kann daher relativ zur Heizplatte 1b nach allen Seiten hin verschoben werden, wobei durch Feinbearbeitung der aneinander gleitenden Flächen beider Teile dafür gesorgt ist, dass der Reibungswiderstand gering ist. Man sieht hier, dass am rechten Rand der Justierplatte 1c der erfindungsgemäße Aktuator 6 angreift, während am gegenüberliegenden Rand ein federnder Anschlag 9 angeordnet ist. Letzterer ist über Federpakete so vorgespannt, dass er die Justierplatte 1c stets in Anlage an dem oder den gegenüberliegenden Aktuatoren 6 hält.

Vorzugsweise bei dem in Figur 2 gezeigten Betriebszustand, also bei geschlossener Presse, aber vor dem Kontaktieren von Substrat 4 und oberer Prägematrize 2d, erfolgt die Messung des Lageversatzes zwischen Substrat und Prägematrize oder wie hier zwischen den beiden Prägematrizen und gegebenenfalls die erforderliche Lagekorrektur durch Aktivierung der Aktuatoren 6.

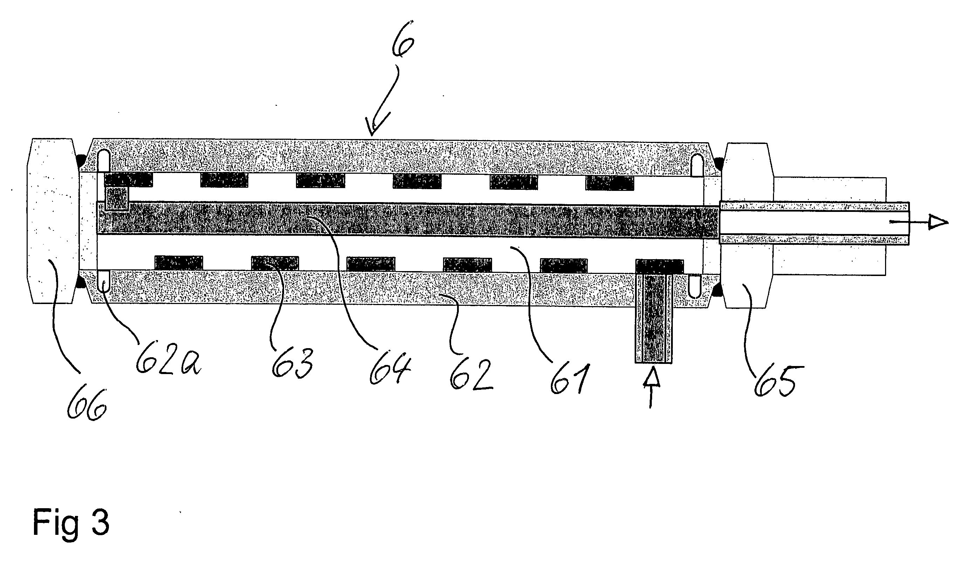

Figur 3 zeigt den Aktuator in vergrößerter Darstellung. Man erkennt, dass er aus einem stangenförmigen Aktuatorkern 61 und einem diesen Kern umgebenden Außenmantel 62 besteht. Der Kern 61 weist an seinem äußeren Umfang einen oder mehrere umlaufende Wärmeträgerkanäle 63 auf, die an ihrem einen Ende in eine zentrale Rücklaufbohrung 64 münden.

An seinem einen Ende ist der Aktuator über einen Lagerbock 65 ortsfest fixiert, etwa durch Montage an der Heizplatte 1b. Der genannte Lagerbock 65 kann dabei gleichzeitig als Anschlag für die Hubbegrenzung beim Zusammenfahren der beiden Pressplatten 1 und 2 dienen.

An seinem anderen Ende greift der Aktuator über ein Druckstück 66 an der Justierplatte 1c an.

Je nachdem, mit welcher Temperatur das Wärmeträgermedium - meist ÖI - in den Kanälen 63 und 64 zirkuliert, dehnt oder verkürzt sich der Aktuator 6 und bewirkt somit in Verbindung mit dem federnden Anschlag 9 eine Verschiebung oder Verschwenkung der Justierplatte 1c.

Der Außenmantel 62 des Aktuators hat meistens nicht die gleiche Temperatur wie der Kern 61. Deshalb ist am Außenmantel 62 zumindest eine Dehnfuge 62a, etwa in Form einer radialen Nut vorgesehen.

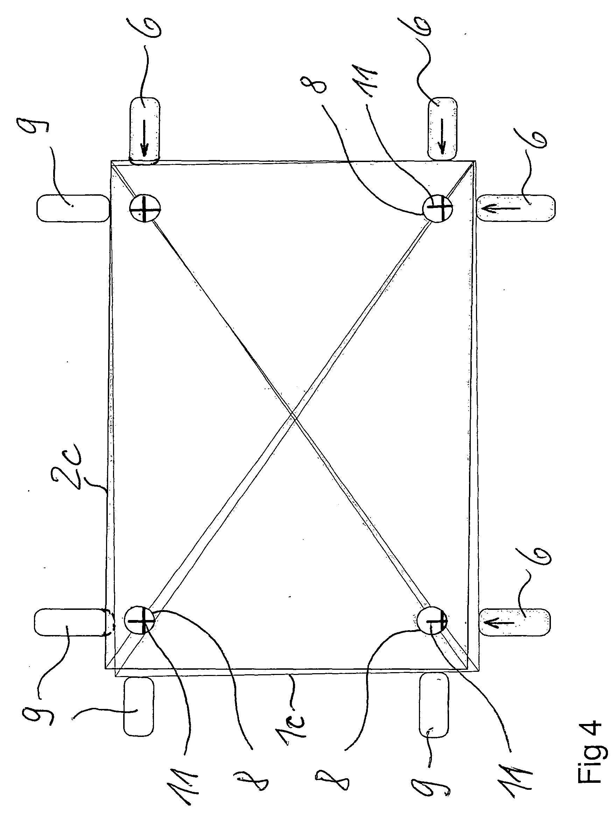

Figur 4 zeigt eine schematische Draufsicht von oben auf die innere Heizplatte 2c und Prägematrize 2d und auf die darunter angeordnete Justierplatte 1c mit Prägematrize 1d in nicht ausgerichtetem Zustand. Man erkennt, dass die Justierplatte 1c an ihrer einen Längs- und Schmalseite von jeweils zwei erfindungsgemäßen Aktuatoren 6 beaufschlagt wird, während sie an der gegenüberliegenden Längs- und Querseite von den gefederten Anschlägen 9 belastet ist. Die Aktuatoren 6 wie auch die Anschläge 9 wirken bevorzugt nahe den Eckbereichen der Justierplatte 1c auf diese ein, weil sich dadurch auch kleine Drehbewegungen der Justierplatte 1c in der Horizontalebene realisieren lassen.

Des weiteren erkennt man, dass auch die Kanäle 8 nahe den Eckbereichen, aber innerhalb des Umfanges der Justierplatte 1c angeordnet sind und dass man durch diese Kanäle Passermarken 11 an der Oberseite der Justierplatte 1c erkennen kann. Je nach dem Versatz - Verschiebung und/oder Verdrehung - sind die Passermarken 11, die hier die Form von Fadenkreuzen haben, mehr oder weniger weit aus dem Zentrum der Kanäle 8, deren kreisförmiger Rand auch als Passermarke fungiert, herausgerückt, so dass jede der vier CCD-Kameras zunächst ein anderes Versatzbild sieht.

Durch ein Rechenprogramm wird nun aufgrund des gemessenen jeweiligen Versatzes der Passermarken die erforderliche Lagekorrektur der Justierplatte 1c ermittelt und die für die Lagekorrektur erforderlichen Stellsignale nach Betrag und Richtung generiert. Diese Stellsignale werden als Solltemperaturwerte den thermostatgesteuerten Wärmeträger-Kreisläufen der jeweiligen Aktuatoren 6 eingegeben, so dass letztere die erforderliche Dehnung oder Kontraktion durchführen, bis die unteren Passermarken 11 im Zentrum der Kanäle 8 liegen.

Bei besonders hohen Genauigkeitsanforderungen kann die beschriebene Lagekorrektur vor jeder neuen Prägung wiederholt werden.

Nach der Lagekorrektur erfolgt dann der eigentliche Prägevorgang. Dies könnte durch weiteres Zusammenfahren der beiden Pressplatten 1 und 2 erfolgen. Im Ausführungsbeispiel ist statt dessen aber unterhalb der unteren Matrize 1d eine zweiwandige, an ihren Rädern verschlossene Membran 12 - vgl. Fig. 2 - vorgesehen, die sich nahezu über den Pressspalt erstreckt und durch Druckmittel-Beaufschlagung die untere Matrize 1d mit dem Substrat 4 gegen die obere Prägematrize 2d presst. Man erhält dadurch eine außerordentlich gleichmäßige homogene Flächenpressung über die gesamte Länge und Breite des Substrates.

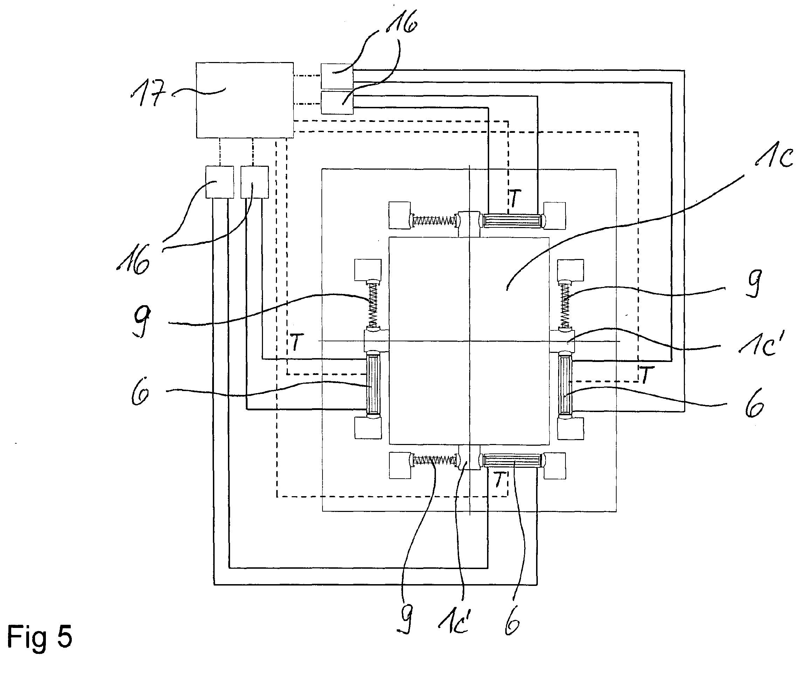

Fig. 5 zeigt schematisch den Ausrichtvorgang und die Steuerung der Aktuatoren. Im Zentrum sitzt die zu verschiebende Justierplatte, hier also die das Substrat 4 tragende innere Heizplatte 1c. Ebenso könnte es sich aber bei der Justierplatte auch allein um die Prägematrize 1d handeln; auch wäre es möglich, den Ausrichtvorgang oberhalb des Pressenspaltes, also an der Prägematrize 2d oder an einem oberhalb derselben angeordneten Teil durchzuführen.

Die Justierplatte 1c ist hier an allen vier Seiten über randseitige Vorsprünge 1c' zwischen Aktuatoren 6 und federnden Anschlägen 9 eingespannt. Man erkennt, dass die vier Aktuatoren 6 jeweils an einen eigenen Fluidkreislauf angeschlossen sind und jeder Fluidkreislauf einen eigenen Thermostat-Regler 16 aufweist. Die Thermostat-Regler 16 sind ihrerseits an eine Steuerungseinheit 17 angeschlossen. Dieses Steuerungseinheit 17 empfängt einerseits die Ist-Wert-Temperaturen T der Aktuatoren 6, andererseits die aus dem gemessenen Versatz der Passermarken errechneten Soll-Temperaturen und steuert demgemäß die Thermostat-Regler 16 individuell indem Sinne, dass die Aktuatoren 6 verkürzt oder verlängert werden, bis der festgestellte Versatz eliminiert ist.

Der gesamte Fertigungsablauf kann wie folgt beschrieben werden:

Die äußeren Heizplatten 1b und 2b sind auf eine Temperatur aufgeheizt, die etwa 70 % bis 80 % der Betriebstemperatur beim Prägen entspricht. Die inneren Heizplatten 1c und 2c und die Prägematrizen 1d und 2d sind auf einer Temperatur gehalten, die der Entnahmetemperatur nach Ende des Prägezyklus entspricht; diese Temperatur kann beispielsweise bei 50 % der Arbeitstemperatur liegen.

Die Presse wird zur Beschickung mit dem Substrat 4 auf maximalen Hub geöffnet. Nach dem Einlegen des Substrates wird die Presse gegen Festanschläge geschlossen, wobei zwischen Substratoberseite und oberer Prägematrize 2d noch ein Abstand von etwa 0,5 mm bis etwa 1 mm verbleibt. Je nach Produkt und Rezeptur kann ab diesem Zeitpunkt und in dieser Hubposition die Kammer 5 evakuiert oder mit Prozessgas, etwa Inertgas, gefüllt werden. Zugleich wird die Temperatur der inneren Heizplatten 1c und 2c und der Prägematrizen auf Betriebstemperatur gebracht. Während dieser Aufheizphase kann bereits eine erste IST-Lage-Erfassung der als Justierplatte 1c fungierenden Heizplatte relativ zur oberen Prägematrize 2d gestartet werden. Aus den hieraus gewonnenen Stellsignalen werden die erfindungsgemäßen Aktuatoren 6 gleichzeitig, aber individuell angesteuert.

Entspricht die neue IST-Lage den vorgegebenen Toleranzbedingungen, so wird der Prägevorgang freigegeben.

Voraussetzung für den Prägevorgang ist außerdem, dass die Arbeitstemperatur in den inneren Heizplatten - gegebenenfalls auch am Substrat 4 und an den Prägematrizen 1d und 2d - erreicht ist. Der Prägevorgang wird dann durch Druckbeaufschlagung der Membran 12, die als hydraulisches Druckkissen fungiert, realisiert.

Dabei werden die Profile und Prägestrukturen der beiden Matrizen 1d und 2d beidseitig in die durch die Arbeitstemperatur erweichte Substratoberfläche gedrückt. Dies ist der eigentliche Prägevorgang.

Nach erfolgter Prägung werden die inneren Heizplatten 1c und 2c und damit auch das Substrat 4 auf eine geeignete Entnahmetemperatur abgekühlt. Danach wird die als Druckkissen wirkende Membran 12 druckentlastet, der Innenraum der Kammer 5 be- oder entlüftet und die Presse zur Entnahme des Substrates geöffnet.

## Patentansprüche

1. Vorrichtung zur Herstellung geprägter Substrate, insbesondere mit dreidimensionalen Oberflächenstrukturen im Mikro- oder Nanobereich, indem das Substrat (4) zwischen zwei relativ zueinander verfahrbaren Pressplatten (1, 2) und zumindest einer Prägematrize (1d, 2d) unter Druck- und Wärmeeinwirkung, gegebenenfalls unter Zwischenschaltung weiterer Teile, Druckkissen oder dergleichen, geprägt wird und wobei die Prägematrize(n) (1d, 2d) und/oder das Substrat (4) vor dem Prägen senkrecht zur Hubrichtung relativ zueinander durch Aktuatoren (6) auszurichten sind,
**dadurch gekennzeichnet,**
**dass** die Aktuatoren (6) thermisch aktivierte Dehnglieder aufweisen, deren Stellweg durch Beheizung und/oder Kühlung steuerbar ist.

2. Vorrichtung nach Anspruch 1,
**dadurch gekennzeichnet,**
**dass** die Aktuatoren (6) Strömungskanäle (63, 64) aufweisen, die an einen thermostatgesteuerten Heiz- und/oder Kühlkreislauf angeschlossen sind.

3. Vorrichtung nach Anspruch 1,
**dadurch gekennzeichnet,**
**dass** die Basistemperatur der Aktuatoren (6) bei etwa 40% bis etwa 60%, vorzugsweise bei etwa 50% der maximalen Stelltemperatur liegt.

4. Vorrichtung nach Anspruch 1,
**dadurch gekennzeichnet,**
**dass** die Aktuatoren (6) stangenförmig ausgebildet sind.

5. Vorrichtung nach Anspruch 1,
**dadurch gekennzeichnet,**
**dass** die Aktuatoren (6) mit zusätzlichen Stellgliedern für eine Grobeinstellung kombiniert sind.

6. Vorrichtung nach Anspruch 1,
**dadurch gekennzeichnet,**
**dass** die Aktuatoren (6) in die Prägevorrichtung integriert, insbesondere im Pressspalt angeordnet sind.

7. Vorrichtung nach Anspruch 1,
**dadurch gekennzeichnet,**
**dass** die Aktuatoren (6) außen von einer Wärme-Isolierung umgeben sind.

8. Vorrichtung nach Anspruch 1,
**dadurch gekennzeichnet,**
**dass** sie ein Messsystem zur Erkennung eines Versatzes zwischen den Prägematrizen (1d, 2d), bzw. zwischen zumindest einer Prägematrize und dem Substrat (4) aufweist.

9. Vorrichtung nach Anspruch 1,
**dadurch gekennzeichnet,**
**dass** zumindest eine Prägematrize (1d, 2) und/oder das Substrat (4) Markierungen zur Feststellung ihrer IST-Position aufweisen.

10. Vorrichtung nach Anspruch 9,
**dadurch gekennzeichnet,**
**dass** die eine Markierung als Bohrung (8) ausgebildet ist.

11. Vorrichtung nach Anspruch 8,
**dadurch gekennzeichnet,**
**dass** das Messsystem an einen die Aktuatoren (6) umfassenden Regelkreis zur Beseitigung des Versatzes angeschlossen ist.

12. Vorrichtung nach Anspruch 8,
**dadurch gekennzeichnet,**
**dass** die Beseitigung des Versatzes erst nach Erreichen der Prägetemperatur an den Prägematrizen (1d, 2d) abgeschlossen wird.

13. Verfahren zur Herstellung geprägter Substrate, insbesondere mit dreidimensionalen Oberflächenstrukturen im Mikro- oder Nanobereich, indem das Substrat (4) zwischen zwei relativ zueinander verfahrbaren Pressplatten (1, 2) und zumindest einer Prägematritze (1d, 2d) unter Druck- und Wärmeeinwirkung, gegebenenfalls unter Zwischenschaltung weiterer Teile wie Druckkissen oder dergleichen, geprägt wird und wobei die Prägematritze(n) (1d, 2d) und/oder das Substrat (4) senkrecht zur Hubrichtung relativ zueinander ausgerichtet werden, insbesondere mittels einer Vorrichtung gemäß einem der Ansprüche 1 bis 12,
**dadurch gekennzeichnet,**
**dass** die Prägematritze(n) (1d, 2d) und/oder das Substrat (4) durch thermisch aktivierte Dehnglieder (6) relativ zueinander ausgerichtet werden, indem die Dehnglieder beheizt und/oder gekühlt werden.

14. Verfahren nach Anspruch 13,
**dadurch gekennzeichnet,**
**dass** Ist-Positionen der Prägematritze(n) (1d, 2d) und/oder des Substrates (4) in der Pressvorrichtung gemessen und korrigiert werden.

15. Verfahren nach Anspruch 14,
**dadurch gekennzeichnet,**
**dass** das Messen der Ist-Positionen vor und/oder während des Hubes, insbesondere des Schließhubes der Pressvorrichtung stattfindet.
